(19) Europäisches Patentamt / European Patent Office / Office européen des brevets

(11) **EP 3 950 876 A1**

# (12) EUROPEAN PATENT APPLICATION
published in accordance with Art. 153(4) EPC

(43) Date of publication:
**09.02.2022 Bulletin 2022/06**

(21) Application number: **20776532.2**

(22) Date of filing: **23.03.2020**

(51) International Patent Classification (IPC):
**C09K 3/14** (2006.01)    **B24B 37/00** (2012.01)
**H01L 21/304** (2006.01)

(52) Cooperative Patent Classification (CPC):
**B24B 37/00; C09K 3/14; H01L 21/304**

(86) International application number:
**PCT/JP2020/012622**

(87) International publication number:
**WO 2020/196369 (01.10.2020 Gazette 2020/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.03.2019 JP 2019058620**

(71) Applicant: **Fujimi Incorporated
Kiyosu-shi, Aichi 452-8502 (JP)**

(72) Inventors:
• **YAMAGUCHI, Yoshiko
  Kiyosu-shi, Aichi 452-8502 (JP)**
• **GOTO, Osamu
  Kiyosu-shi, Aichi 452-8502 (JP)**
• **TSUCHIYA, Kohsuke
  Kiyosu-shi, Aichi 452-8502 (JP)**
• **ICHITSUBO, Taiki
  Kiyosu-shi, Aichi 452-8502 (JP)**

(74) Representative: **Grünecker Patent- und
Rechtsanwälte
PartG mbB
Leopoldstraße 4
80802 München (DE)**

(54) **POLISHING COMPOSITION**

(57)    The polishing composition provided by the present invention contains an abrasive, a polyvinyl alcohol polymer as a water-soluble polymer, a basic compound, and water, and further contains a trivalent or higher polyvalent organic acid (salt).

## Description

## Technical Field

The present invention relates to a polishing composition. The present application claims priority based on Japanese Patent Application No. 2019-058620 filed on March 26, 2019, the entire contents of which application are incorporated herein by reference.

## Background Art

Precision polishing using a polishing composition is performed on the surface of a material such as a metal, a metalloid, a nonmetal, and an oxide thereof or the like. For example, the surface of a silicon wafer used as a component of a semiconductor device and the like is generally finished to a high-quality mirror surface through a lapping step (rough polishing step) and a polishing step (fine polishing step). The polishing step typically includes a stock polishing step and a final polishing step. Patent Literature 1 to 4 are cited as technical literature on polishing compositions mainly used for application to polish semiconductor substrates such as silicon wafers.

Citation List

Patent Literature

Patent Literature 1 : Japanese Patent Application Publication No. HI 1-140427
Patent Literature 2 : Japanese Patent No. 5474400
Patent Literature 3 : Japanese Patent No. 6029895
Patent Literature 4 : Japanese Patent No. 6050125

## Summary of Invention

Technical Problem

The polishing composition used in the final polishing step (especially in the final polishing step for substrates including semiconductor substrates such as silicon wafers) is required to be capable of yielding a high-quality surface after polishing. In addition to abrasive and water, polishing compositions for such applications often include water-soluble polymers for the purpose of protecting the surface of an object to be polished, improving wettability and the like.

The wettability of a surface after polishing can be favorably improved by using a polyvinyl alcohol polymer as a water-soluble polymer. In recent years, however, the requirements for surface quality after polishing have increased still more. It is therefore an object of the invention to provide a polishing composition containing a polyvinyl alcohol polymer as a water-soluble polymer, whereby the surface quality of an object to be polished after polishing can be improved.

Solution to Problem

The polishing composition provided by this Description contains an abrasive, a polyvinyl alcohol polymer as a water-soluble polymer, a basic compound, and water. The polishing composition further contains a trivalent or higher polyvalent organic acid (salt). With use of the polyvalent organic acid (salt), the surface quality of an object to be polished can be improved after polishing by a polishing composition containing a polyvinyl alcohol polymer. For example, haze can be improved.

In this Description, "acid (salt)" is a term that comprehensively refers to an acid and a salt of that acid, which may also be represented as an "acid and/or salt thereof'. For example, saying that the polishing composition disclosed here contains a trivalent or higher polyvalent organic acid (salt) means that the composition contains at least one selected from the group consisting of the trivalent and higher polyvalent organic acids and salts thereof.

The polishing composition of a preferred embodiment contains a trivalent or higher polyvalent carboxylic acid (salt) as the polyvalent organic acid (salt). A haze improvement effect can be favorably achieved in this embodiment.

The polishing composition of another preferred embodiment contains an ammonium salt of a trivalent or higher polyvalent organic acid as the polyvalent organic acid (salt). With an ammonium salt of a polyvalent organic acid, haze can be effectively improved even when a small amount is used.

In some embodiments of the polishing composition disclosed here, the dispersibility of the polishing composition as calculated by formula below:

$$\text{Dispersibility [nm]} = (d_{84} - d_{16})/2$$

is preferably less than 10.8 nm, where $d_{84}$ in formula above is a particle diameter [nm] at a point at which the cumulative curve of a particle size distribution is 84%, and $d_{16}$ is a particle diameter [nm] at a point at which the cumulative curve of a particle size distribution is 16%. With this polishing composition, haze on the surface of an object to be polished after polishing can be effectively improved in a configuration containing a polyvinyl alcohol polymer.

In some embodiments of the polishing composition disclosed here, the polishing composition further contains a water-soluble polymer other than the polyvinyl alcohol polymer (hereunder also called the "other water-soluble polymer"). The dispersibility of this polishing composition is preferably less than 14.2 nm as measured by formula below:

$$\text{Dispersibility [nm]} = (d_{84} - d_{16})/2$$

in which $d_{84}$ and $d_{16}$ are defined as above. With this polishing composition, haze on the surface of an object to be polished can be effectively improved after polishing in a configuration combining a polyvinyl alcohol polymer and another water-soluble polymer.

In some embodiments of the polishing composition disclosed here, the polishing composition has a ratio of increase in electrical conductivity of not more than 3 due to the inclusion of the organic acid (salt). It is thus possible to achieve a polishing composition whereby haze is greatly improved.

In a preferred embodiment of the polishing composition disclosed here, a pH of the composition is 8 to 12. Haze can be favorably improved in polishing using a polishing composition having such a pH.

A polymer with a weight-average molecular weight (Mw) of not more than $10 \times 10^4$ can be used by preference as the polyvinyl alcohol polymer. The haze improvement effect can be more favorably exerted by using a polyvinyl alcohol having such an Mw in combination with a polyvalent organic acid (salt).

A silica particle is preferred as the abrasive. The haze improvement effect achieved by using a polyvinyl alcohol polymer in combination with a polyvalent organic acid (salt) can be favorably exerted in polishing using a silica particle as an abrasive.

The polishing composition disclosed here can be used by preference in a final polishing step for a silicon wafer. By performing final polishing with the polishing composition, it is possible to improve haze and favorably obtain a high-quality silicon wafer surface.

**Description of Embodiments**

Preferred embodiments of the present invention are explained below. Matters other than those specifically mentioned in this Description that are necessary for implementing the present invention can be understood as design matters by a person skilled in the art based on prior art in the field. The present invention can be implemented based on the contents disclosed in this Description and technical common knowledge in the field.

The polishing composition disclosed here contain an abrasive, a polyvinyl alcohol polymer as a water-soluble polymer, a polyvalent organic acid (salt), a basic compound, and water. The contents of the polishing composition disclosed here are explained below.

<Abrasive>

The polishing composition disclosed here contains an abrasive. The abrasive works to mechanically polish the surface of an object to be polished. The material and properties of the abrasive are not particularly limited and may be selected appropriately according to the purpose of use, mode of use and the like of the polishing composition. Examples of abrasives include inorganic particles, organic particles, and organic-inorganic composite particles. Specific examples of inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles and red iron oxide particles; nitride particles such as silicon nitride particles and boron nitride particles; carbide particles such as silicon carbide particles and boron carbide particles; diamond particles; and carbonate salts such as calcium carbonate and barium carbonate and the like. Specific examples of organic particles include polymethyl methacrylate (PMMA) particles, poly(meth)acrylic acid particles (the meaning of "(meth)acrylic acid" here encompasses both acrylic acid and methacrylic acid), and polyacrylonitrile particles and the like. One of these abrasives may be used alone, or two or more kinds may be combined.

An inorganic particle is preferred as the abrasive, and of these, a particle consisting of an oxide of a metal or metalloid is more preferred, and a silica particle is especially preferred. The use of a silica particle is especially significant in a polishing composition that may be used for polishing (for example final polishing) an object to be polished that has a surface consisting of silicon, such as the silicon wafer described below. The technology disclosed here can be preferably implemented for example as an embodiment in which the abrasive consists substantially of silica particles. "Substantially" here means that at least 95 wt% (preferably at least 98 wt%, or more preferably at least 99 wt%, or 100 wt%) of the particles constituting the abrasive are silica particles.

Specific examples of silica particles include colloidal silica, fumed silica, precipitated silica and the like. One of these alone or a combination of two or more kinds may be used as the silica particle. Colloidal silica is especially desirable for easily obtaining a polished surface with excellent surface quality after polishing. Colloidal silica prepared by an ion exchange method using water glass (sodium silicate) as a raw material or alkoxide method colloidal silica (colloidal silica manufactured by a hydrolytic condensation reaction from alkoxysilane) can be used by preference as the colloidal silica. One kind of colloidal silica alone or a combination of two or more kinds may be used.

The true specific gravity of the material constituting the abrasive (such as the silica constituting a silica particle) is preferably at least 1.5, or more preferably at least 1.6, or still more preferably at least 1.7. There is no particular upper limit to the true specific gravity of the silica, which is typically not more than 2.3, or not more than 2.2 for example. A measurement value from liquid displacement measurement using ethanol as the displacement liquid may be used as the true specific gravity of the abrasive (for example, the silica particle).

The BET diameter (average primary particle diameter) of the abrasive is not particularly limited, but considering the polishing removal rate and the like, is preferably at least 5 nm, or more preferably at least 10 nm. To achieve greater polishing effects (such as for example haze reduction or defect removal), the BET diameter is more preferably at least 15 nm, or still more preferably at least 20 nm (such as over 20 nm). From the standpoint of scratch prevention and the like, the BET diameter of the abrasive is preferably not more than 100 nm, or more preferably not more than 50 nm, or still more preferably not more than 40 nm. To easily achieve a surface with lower haze, the BET diameter of the abrasive in some embodiments may also be not more than 35 nm, or less than 32 nm, or less than 30 nm.

The BET diameter in this Description is the particle diameter as calculated by the formula: BET diameter (nm) = 6,000/(true density (g/cm$^3$) $\times$ BET value (m$^2$/g)) from the specific surface area (BET value) as measured by the BET method. For example, in the case of a silica particle the BET diameter can be calculated as BET diameter (nm) = 2,727/BET value (m$^2$/g). The specific surface area can be measured using a Flow Sorb II 2300 (product name) surface area analyzer manufactured by Micromeritics Instrument Corporation.

The shape (outer shape) of the abrasive may be globular or non-globular. Specific examples of non-globular particle shapes include a peanut shape, a cocoon shape, a conpeito shape, a rugby ball shape, and the like. For example, an abrasive in which most of the particles have a peanut shape or a cocoon shape can preferably be used.

The average major axis/minor axis ratio of the abrasive (average aspect ratio) is not particularly limited, but is in principle at least 1.0, or preferably at least 1.05, or more preferably at least 1.1. A greater polishing efficiency can be achieved by increasing the average aspect ratio. From the standpoint of scratch reduction and the like, the average aspect ratio of the abrasive is preferably not more than 3.0, or more preferably not more than 2.0, or still more preferably not more than 1.5.

The shape (external shape) and average aspect ratio of the abrasive can be determined for example by electron microscopy. As a specific procedure for determining the average aspect ratio, for example the smallest rectangle circumscribing the particle image of each individual particle is drawn for a predetermined number (such as 200) abrasive particles whose independent particle shapes can be recognized under a scanning electron microscope (SEM). For the rectangle drawn around each particle image, the value of the length of the long side (major axis value) divided by the length of the short side (minor axis value) is calculated as the major axis/minor axis ratio (aspect ratio). The average is calculated from the aspect ratios of the predetermined number of particles to determine the average aspect ratio.

<Water-soluble polymer>

The polishing composition disclosed here contains a water-soluble polymer. The water-soluble polymer can be useful for protecting the surface of an object to be polished and improving the wettability of the surface of the object to be polished after polishing.

(Polyvinyl alcohol polymer)

The polishing composition disclosed here contain a polyvinyl alcohol polymer as a water-soluble polymer. A water-soluble organic material (typically a water-soluble polymer) containing vinyl alcohol units as repeating units can be used as the polyvinyl alcohol polymer. A vinyl alcohol unit (hereunder also called a "VA unit") here is a structural part represented by the chemical formula: $-CH_2-CH(OH)-$. The polyvinyl alcohol polymer may contain only VA units as repeating units but may also contain a unit other than a VA unit (hereunder also called a "non-VA unit") as a repeating unit. The polyvinyl alcohol polymer may be a random copolymer or a block copolymer or graft copolymer containing VA units and non-VA units. The polyvinyl alcohol polymer may contain one kind of non-VA unit, or multiple kinds of non-VA units.

The polyvinyl alcohol polymer used in the polishing composition disclosed here may be an unmodified polyvinyl alcohol (unmodified PVA), or a modified polyvinyl alcohol (modified PVA). An unmodified PVA here is a polyvinyl alcohol polymer produced by hydrolysis (saponification) of polyvinyl acetate and containing substantially no repeating units other than VA units and repeating units ($-CH_2-CH(OCOCH_3)-$) of a structure produced by vinyl polymerization of vinyl acetate. The degree of saponification of the unmodified PVA may be at least 60% for example, or at least 70% from the standpoint of water solubility, or at least 80%, or at least 90%. In certain embodiments, unmodified PVA with a degree of saponification of at least 95% or at least 98% may be used by preference as a water-soluble polymer compound.

Examples of non-VA units that can be contained in modified PVA include, but are not limited to, repeating units derived from the N-vinyl type monomers and N-(meth)acryloyl type monomers described below, repeating units derived from ethylene, repeating units derived from alkyl vinyl ethers, and repeating units derived from vinyl esters of monocarboxylic acids with three or more carbon atoms. N-vinyl pyrrolidone is a preferred example of the above N-vinyl type monomers. N-(meth)acryloyl morpholine is a preferred example of the above N-(meth)acryloyl type monomers. The above alkyl vinyl ethers include for example vinyl ethers having $C_{1-10}$ alkyl groups, such as propyl vinyl ether, butyl vinyl ether, 2-ethylhexyl vinyl ether and the like. The above vinyl esters of monocarboxylic acids with three or more carbon atoms include for example $C_{3-7}$ monocarboxylic acid vinyl esters such as vinyl propanoate, vinyl butanoate, vinyl pentanoate and vinyl hexanoate.

The polyvinyl alcohol polymer may also be a modified PVA containing VA units as well as non-VA units having at least one structure selected from the oxyalkylene, carboxy, sulfo, amino, hydroxyl, amido, imido, nitrile, ether and ester groups and salts of these. The polyvinyl alcohol polymer may also be a modified PVA in which some of the VA units contained in the polyvinyl alcohol polymer have been acetalized with an aldehyde. An alkyl aldehyde can be used by preference as the aldehyde, of which an alkyl aldehyde having a $C_{1-7}$ alkyl group is preferred, and n-butyl aldehyde is more preferred. A cation-modified polyvinyl alcohol having an introduced cationic group such as a quaternary ammonium structure may also be used as the polyvinyl alcohol polymer. Examples of the cation-modified polyvinyl alcohol include those having cationic groups derived from monomers such as diallyl dialkyl ammonium salts and N-(meth)acryloyl aminoalkyl-N,N,N-trialkyl ammonium salts having cationic groups.

The molar ratio of VA units as a percentage of the total molar amount of repeating units constituting the polyvinyl alcohol polymer may be at least 5% for example, and may also be at least 10%, or at least 20%, or at least 30%. Although this is not a particular limitation, in some embodiments the molar ratio of these VA units may be at least 50%, or at least 65%, or at least 75%, or at least 80%, or at least 90% (such as at least 95%, or at least 98% for example). VA units may also constitute substantially 100% of the repeating units constituting the polyvinyl alcohol polymer. "Substantially 100%" here means that non-VA units are at least not included intentionally in the polyvinyl alcohol polymer, and typically means that the molar ratio of non-VA units as a percentage of the total molar amount of repeating units is less than 2% (such as less than 1%) and includes cases in which it is 0%. In certain other embodiments, the molar ratio of VA units as a percentage of the total molar amount of repeating units constituting the polyvinyl alcohol polymer may be not more than 95% for example, or not more than 90%, or not more than 80%, or not more than 70%.

The content of VA units (weight-based content) in the polyvinyl alcohol polymer may be for example at least 5 wt%, or at least 10 wt%, or at least 20 wt%, or at least 30 wt%. Although not particularly limited, in certain embodiments the content of these VA units may be at least 50 wt% (such as above 50 wt%), or at least 70 wt%, or at least 80 wt% (such as at least 90 wt%, or at least 95 wt%, or at least 98 wt%). Substantially 100 wt% of the repeating units constituting the polyvinyl alcohol polymer may also be VA units. "Substantially 100 wt%" here means that non-VA units are at least not included intentionally in the repeating units constituting the polyvinyl alcohol polymer, and typically means that the content of non-VA units in the polyvinyl alcohol polymer is less than 2 wt% (such as less than 1 wt%). In certain other embodiments, the content of VA units in the polyvinyl alcohol polymer may be not more than 95 wt%, or not more than 90 wt%, or not more than 80 wt%, or not more than 70 wt%, for example.

The polyvinyl alcohol polymer may also contain multiple polymer chains with differing contents of VA units within the same molecule. A polymer chain here is a part (segment) constituting part of a single molecule polymer. For example, one molecule of the polyvinyl alcohol polymer may contain a polymer chain A with a VA unit content greater than 50 wt% and a polymer chain B with a VA unit content of less than 50 wt% (that is, with a non-VA unit content greater than 50 wt%).

The polymer chain A may contain only VA units as repeating units but may also contain non-VA units in addition to VA units. The content of VA units in the polymer chain A may be at least 60 wt%, or at least 70 wt%, or at least 80 wt%, or at least 90 wt%. In certain embodiments, the content of VA units in the polymer chain A may also be at least 95 wt%, or at least 98 wt%. Substantially 100 wt% of the repeating units constituting the polymer chain A may also be VA units.

The polymer chain B may contain only non-VA units as repeating units or may contain VA units in addition to non-VA units. The content of non-VA units in the polymer chain B may be at least 60 wt%, or at least 70 wt%, or at least 80 wt%, or at least 90 wt%. In certain embodiments, the content of non-VA units in the polymer chain B may also be at least 95 wt%, or at least 98 wt%. Substantially 100% of the repeating units constituting the polymer chain B may also be non-VA units.

Polyvinyl alcohol polymers containing a polymer chain A and a polymer chain B in the same molecule include block copolymers and graft copolymers containing these polymer chains. Such a graft copolymer may have a structure comprising the polymer chain B (side chain) grafted to the polymer chain A (main chain), or a structure comprising the polymer chain A (side chain) grafted to the polymer chain B (main chain). In one embodiment, a polyvinyl alcohol polymer having a structure comprising the polymer chain B grafted to the polymer chain A may be used.

Examples of the polymer chain B include polymer chains having repeating units derived from N-vinyl monomers as principal repeating units, polymer chains having repeating units derived from N-(meth)acryloyl monomers as principal repeating units, and polymer chains having oxyalkylene units as principal repeating units. Unless otherwise specified, a principal repeating unit in this Description is a repeating unit contained in the amount of over 50 wt%.

A preferred example of the polymer chain B is a polymer chain having N-vinyl monomer units as principal repeating units, or in other words an N-vinyl polymer chain. The content of the repeating units derived from the N-vinyl monomer in an N-vinyl polymer chain is typically more than 50 wt%, and may also be at least 70 wt%, or at least 85 wt%, or at least 95 wt%. Substantially all of the polymer chain B may also be made up of repeating units derived from an N-vinyl monomer.

In this Description, examples of N-vinyl monomers include N-vinyl chain amides and monomers having heterocycles (such as lactam rings) containing nitrogen. Specific examples of N-vinyl lactam monomers include N-vinyl pyrrolidone, N-vinyl piperidone, N-vinyl morpholinone, N-vinyl caprolactam, N-vinyl-1,3-oxazine-2-one, N-vinyl-3,5-morpholinedione and the like. Specific examples of N-vinyl chain amides include N-vinyl acetamide, N-vinyl propionamide, N-vinyl butyramide and the like. For example, the polymer chain B may be an N-vinyl polymer chain in which more than 50 wt% (such as at least 70 wt%, or at least 85 wt%, or at least 95 wt%) of the repeating units are N-vinyl pyrrolidone units. Substantially all of the repeating units constituting the polymer chain B may also be N-vinyl pyrrolidone units.

Other examples of the polymer chain B include polymer chains having repeating units derived from N-(meth)acryloyl monomers as principal repeating units, or in other words N-(meth)acryloyl polymer chains. The content of the repeating units derived from the N-(meth)acryloyl monomer in an N-(meth)acryloyl polymer chain is typically more than 50 wt%, and may also be at least 70 wt%, or at least 85 wt%, or at least 95 wt%. Repeating units derived from the N-(meth)acryloyl monomer may also constitute substantially all of the repeating units of the polymer chain B.

In this Description, examples of N-(meth)acryloyl monomers include chain amides having N-(meth)acryloyl groups and cyclic amides having N-(meth)acryloyl groups. Examples of chain amides having N-(meth)acryloyl groups include (meth)acrylamide; N-alkyl (meth)acrylamides such as N-methyl (meth)acrylamide, N-ethyl (meth)acrylamide, N-propyl (meth)acrylamide, N-isopropyl (meth)acrylamide and N-n-butyl (meth)acrylamide; and N,N-dialkyl (meth)acrylamides such as N,N-dimethyl (meth)acrylamide, N,N-diethyl (meth)acrylamide, N,N-dipropyl (meth)acrylamide, N,N-diisopropyl (meth)acrylamide and N,N-di(n-butyl) (meth)acrylamide and the like. Examples of cyclic amides having N-(meth)acryloyl groups include N-(meth)acryloyl morpholine and N-(meth)acryloyl pyrrolidone and the like.

Other examples of the polymer chain B include polymer chains containing oxyalkylene units as principal repeating units, or in other words oxyalkylene polymer chains. The content of the oxyalkylene units in an oxyalkylene polymer chain is typically more than 50 wt%, and may also be at least 70 wt%, or at least 85 wt%, or at least 95 wt%. Oxyalkylene units may also constitute substantially all of the repeating units of the polymer chain B.

Examples of oxyalkylene units include oxyethylene units, oxypropylene units, oxybutylene units and the like. Such oxyalkylene units may be repeating units derived from the corresponding alkylene oxide. One kind or two or more kinds of oxyalkylene units may be contained in an oxyalkylene polymer chain. For example, an oxyalkylene polymer chain containing a combination of oxyethylene units and oxypropylene units is possible. In an oxyalkylene polymer chain containing two or more kinds of oxyalkylene units, these oxyalkylene units may constitute a random copolymer or a block copolymer or graft copolymer of the corresponding alkylene oxides.

Other examples of the polymer chain B include polymer chains containing repeating units derived from alkyl vinyl ethers (such as vinyl ethers having $C_{1-10}$ alkyl groups), polymer chains containing repeating units derived from monocarboxylic acid vinyl esters (such as vinyl esters of monocarboxylic acids with 3 or more carbon atoms), polymer chains in which some VA units have been acetalized with an aldehyde (such as an alkyl aldehyde having a $C_{1-7}$ alkyl group), and polymer chains having introduced cationic groups (such as cationic groups having quaternary ammonium structures) and the like.

Either unmodified PVA, or modified PVA, or a combination unmodified PVA and modified PVA, may be used as the polyvinyl alcohol polymer in the polishing composition disclosed here. When unmodified PVA and modified PVA are used together, the amount of the modified PVA relative to the total amount of the polyvinyl alcohol polymer contained in the polishing composition may be less than 95 wt% for example, or not more than 90 wt%, or not more than 75 wt%, or not more than 50 wt%, or not more than 30 wt%, or not more than 10 wt%, or not more than 5 wt%, or not more than 1 wt%. The polishing composition disclosed here may preferably be implemented as an embodiment using only one or two or more kinds of unmodified PVA for the polyvinyl alcohol polymer.

The weight-average molecular weight (Mw) of the polyvinyl alcohol polymer used in the polishing composition disclosed here is not particularly limited. The Mw of the polyvinyl alcohol polymer is normally not more than about $100 \times 10^4$, or preferably not more than about $30 \times 10^4$, and may also be not more than $20 \times 10^4$. The lower the Mw of the polyvinyl alcohol polymer, the more the dispersion stability of the polyvinyl alcohol polymer tends to improve. From this perspective, the Mw of the polyvinyl alcohol polymer in some embodiments may be not more than $15 \times 10^4$, or not more than $10 \times 10^4$. The Mw of the polyvinyl alcohol polymer is also normally at least $2 \times 10^3$ and may also be at least $5 \times 10^3$, or at least $1 \times 10^4$. The effects of protecting the object to be polished and improving wettability tend to increase as the Mw of the polyvinyl alcohol polymer increases. From this perspective, the Mw of the polyvinyl alcohol polymer used in the polishing composition disclosed here is preferably at least $5 \times 10^3$, or more preferably at least $1 \times 10^4$, and may also be at least $2 \times 10^4$, or at least $5 \times 10^4$, or at least $6 \times 10^4$, or at least $6.5 \times 10^4$.

Values obtained from water-based gel permeation chromatography (GPC) (water-based, polyethylene oxide conversion) may be adopted for the weight-average molecular weights (Mw) of the water-soluble polymer and the surfactant (described below) in this Description. A Tosoh HLC-8320GPC may be used as the GPC measurement apparatus. Measurement may be performed under the following conditions for example. Similar methods are also used in the examples below.

[GPC Measurement Conditions]

Sample concentration: 0.1 wt%
Column: TSKgel GMPWXL
Detector: Differential refractometer
Eluent: 100 mM sodium nitrate aqueous solution/acetonitrile = (10 to 8)/(0 to 2)
Flow rate: 1 ml/minute
Measurement temperature: 40°C
Sample injection volume: 200 $\mu$l

The content of the polyvinyl alcohol polymer in the polishing composition (when two or more kinds of polyvinyl alcohol polymer are included, the total content of these) is not particularly limited. To improve polishing performance and surface quality, the content in certain embodiments may be for example at least 0.0001 wt%, or normally at least 0.00025 wt%, or preferably at least 0.0004 wt%, or for example at least 0.0005 wt%. The maximum content of the polyvinyl alcohol polymer is not particularly limited and may be not more than 0.05 wt% for example. Considering the stability at the concentrated stage and the polishing removal rate, cleanability and the like, in certain embodiments the content of the polyvinyl alcohol polymer is preferably not more than 0.035 wt%, or more preferably not more than 0.025 wt%, or still more preferably not more than 0.02 wt%, or especially not more than 0.015 wt%, or for example not more than 0.0125 wt%, or typically not more than 0.01 wt%. The polishing composition disclosed here can preferably be implemented as an embodiment in which the content of the polyvinyl alcohol polymer is not more than 0.008 wt%, or not more than 0.006 wt%, or not more than 0.004 wt% for example.

The content of the polyvinyl alcohol polymer (when two or more kinds of polyvinyl alcohol polymer are included, the total content of these) may also be specified in terms of relative content relative to the content of the abrasive. This is not particularly limited, but in certain embodiments the content of the polyvinyl alcohol polymer per 100 parts by weight of the abrasive may be for example at least 0.01 parts by weight, or at least 0.1 parts by weight from the perspective of reducing haze, or preferably at least 0.5 parts by weight, or more preferably at least 1 part by weight, or still more preferably at least 3 parts by weight. The content of the polyvinyl alcohol polymer per 100 parts by weight of the abrasive may also be not more than 50 parts by weight, or not more than 30 parts by weight. Considering the dispersion stability and the like of the polishing composition, in some embodiments the content of the polyvinyl alcohol polymer per 100 parts by weight of the abrasive may suitably be not more than 15 parts by weight, or preferably not more than 10 parts by weight, or more preferably not more than 8 parts by weight, or not more than 7 parts by weight. The polishing composition disclosed here may preferably be implemented as an embodiment in which the content of the polyvinyl alcohol polymer per 100 parts by weight of the abrasive is less than 5 parts by weight, or less than 3 parts by weight, or less than 2 parts by weight.

(Other water-soluble polymer)

The polishing composition disclosed here may also contain another water-soluble polymer, or in other words a water-soluble polymer other than a polyvinyl alcohol polymer as necessary, to the extent that the effects of the invention are not significantly impaired thereby. The other water-soluble polymer may be selected appropriately from water-soluble polymers known in the field of polishing compositions. Examples of the other water-soluble polymer include synthetic polymers including polymers containing oxyalkylene units and polymers containing nitrogen atoms; and naturally derived polymers such as cellulose derivatives and starch derivatives and the like.

Examples of polymers containing oxyalkylene units include block copolymers of polyethylene oxide (PEO) or ethylene oxide (EO) with propylene oxide (PO) or butylene oxide (BO), as well as random copolymers of EO with PO or BO and the like. Of these, a block copolymer of EO and PO or a random copolymer of EO and PO is preferred. A block copolymer of EO and PO may be either a diblock or triblock copolymer containing PEO blocks and polypropylene oxide (PPO) blocks. Examples of triblock forms include PEO-PPO-PEO triblock forms and PPO-PEO-PPO triblock forms. Of these, a PEO-PPO-PEO triblock copolymer is preferred.

In a block copolymer or random copolymer of EO and PO, the molar ratio (EO/PO) of the EO and PO constituting the copolymer is preferably greater than 1 from the standpoint of the solubility in water and cleanability, or preferably at least 2, or more preferably at least 3 (such as at least 5).

Non-limiting examples of polymers containing nitrogen atoms include polymers containing N-vinyl monomer units, imine derivatives, and polymers containing N-(meth)acryloyl monomer units and the like.

Examples of polymers containing N-vinyl monomer units include polymers containing repeating units derived from monomers having heterocycles (such as lactam rings) containing nitrogen. Examples of such polymers include homopolymers and copolymers of N-vinyl lactam monomers (for example, copolymers having N-vinyl lactam monomer copolymerization ratios exceeding 50 wt%) and homopolymers and copolymers of N-vinyl chain amides (for example, copolymers having N-vinyl chain amide copolymerization ratios exceeding 50 wt%) and the like.

Specific examples of N-vinyl lactam monomers (that is, compounds having a lactam structure and an N-vinyl group in one molecule) include N-vinyl pyrrolidone (VP), N-vinyl piperidone, N-vinyl morpholinone, N-vinyl caprolactam (VC), N-vinyl-1,3-oxazine-2-one, N-vinyl-3,5-morpholinedione and the like. Specific examples of polymers containing N-vinyl lactam monomer units include polyvinyl pyrrolidone, polyvinyl caprolactam, random copolymers of VP and VC, random copolymers of VP and/or VC with another vinyl monomer (such as an acrylic monomer or vinyl ester monomer), and block copolymers or graft copolymers having polymer chains containing VP and/or VC.

Specific examples of N-vinyl chain amides include N-vinyl acetamide, N-vinyl propionamide, N-vinyl butyramide and the like.

Examples of polymers having N-(meth)acryloyl monomer units include homopolymers and copolymers of N-(meth)acryloyl monomers (typically, copolymers having an N-(meth)acryloyl monomer copolymerization ratio exceeding 50 wt%). Examples of N-(meth)acryloyl monomers include chain amides having N-(meth)acryloyl groups and cyclic amides having N-(meth)acryloyl groups.

Examples of chain amides having N-(meth)acryloyl groups include (meth)acrylamide; N-alkyl (meth)acrylamides such as N-methyl (meth)acrylamide, N-ethyl (meth)acrylamide, N-propyl (meth)acrylamide, N-isopropyl (meth)acrylamide and N-n-butyl (meth)acrylamide; and N,N-dialkyl (meth)acrylamides such as N,N-dimethyl (meth)acrylamide, N,N-diethyl (meth)acrylamide, N,N-dipropyl (meth)acrylamide, N,N-diisopropyl (meth)acrylamide and N,N-di(n-butyl) (meth)acrylamide and the like. Examples of polymers containing chain amides having N-(meth)acryloyl groups as monomer units include homopolymers of N-isopropyl acrylamide and copolymers of N-isopropyl acrylamide (for example, copolymers having N-isopropyl acrylamide copolymerization ratios exceeding 50 wt%).

Examples of cyclic amides having N-(meth)acryloyl groups include N-acryloyl morpholine, N-acryloyl thiomorpholine, N-acryloyl piperidine, N-acryloyl pyrrolidine, N-methacryloyl morpholine, N-methacryloyl piperidine, N-methacryloyl pyrrolidine and the like. Examples of polymers containing cyclic amides having N-(meth)acryloyl groups as monomer units include acryloyl morpholine polymers (PACMO). Typical examples of acryloyl morpholine polymers include homopolymers of N-acryloyl morpholine (ACMO) and copolymers of ACMO (for example, copolymers having ACMO copolymerization ratios exceeding 50 wt%). In an acryloyl morpholine polymer, the molar ratio of ACMO units as a percentage of the total molar amount of all repeating units is normally at least 50% and may suitably be at least 80% (such as at least 90%, or typically at least 95%). ACMO units may also constitute substantially all of the repeating units of the water-soluble polymer.

Other examples of polymers containing nitrogen atoms include homopolymers and copolymers of N-acylalkylene imine type monomers. Specific examples of N-acylalkylene imine type monomers include N-acetyl ethylenimine, N-propionyl ethylenimine and the like.

Cellulose derivatives are polymers containing beta-glucose units as principal repeating units, and include for example methyl cellulose, ethyl cellulose, hydroxyethyl cellulose (HEC), methyl hydroxyethyl cellulose and the like. Starch derivatives are polymers containing alpha-glucose units as principal repeating units, and include for example alpha starch, pullulan, carboxymethyl starch, cyclodextrin and the like.

The molecular weight of the other water-soluble polymer is not particularly limited in the technology disclosed here. The weight-average molecular weight (Mw) of the other water-soluble polymer may be for example not more than $100 \times 10^4$, and from the standpoint of the cleanability and the like is normally not more than $60 \times 10^4$, or may be not more than $50 \times 10^4$, or not more than $40 \times 10^4$. In certain embodiments, the Mw of the other water-soluble polymer is preferably not more than $20 \times 10^4$ and may be for example not more than $10 \times 10^4$, or not more than $8 \times 10^4$. From the standpoint of protecting the object to be polished, the Mw of the other water-soluble polymer may be for example at least 2,000, and normally at least 5,000 is preferred. In certain embodiments, the Mw may suitably be at least $1.0 \times 10^4$, and is preferably at least $1.5 \times 10^4$, or more preferably at least $2 \times 10^4$, or still more preferably at least $3 \times 10^4$, or for example at least $4 \times 10^4$, or typically at least $5 \times 10^4$, and may also be at least $10 \times 10^4$, or at least $20 \times 10^4$, or at least $30 \times 10^4$.

One kind of polymer alone or a combination of two or more kinds may be used as the other water-soluble polymer. The relationship between the amounts of the polyvinyl alcohol polymer and the other water-soluble polymer is not particularly limited, but the weight ratio may be for example from 5:95 to 95:5, or from 10:90 to 90:10, or from 25:75 to 75:25.

In certain embodiments, the weight ratio (polyvinyl alcohol polymer:other water-soluble polymer) may be for example from 50:50 to 100:0, or from 80:20 to 100:0, or from 90:10 to 100:0.

In certain other embodiments, the weight ratio of the polyvinyl alcohol polymer to the other water-soluble polymer may be for example from 5:95 to 70:30, or from 15:85 to 50:50, or from 20:80 to 40:60.

The above effects of using a trivalent or higher polyvalent organic acid (salt) can also be suitably achieved in an embodiment containing such a combination of a polyvinyl alcohol polymer with another water-soluble polymer (for example, a synthetic polymer such as a polymer containing oxyalkylene units or a polymer containing nitrogen atoms).

To reduce aggregates and improve the cleanability, a nonionic polymer may be used by preference as the other water-soluble polymer. To easily control the chemical structure and purity, a synthetic polymer is desirable as the other water-soluble polymer. The polishing composition disclosed here can preferably be implemented as an embodiment in which substantially no naturally derived polymer is used as the water-soluble polymer. "Substantially no" here means that the amount relative to 100 parts by weight of the polyvinyl alcohol polymer is typically not more than 3 parts by weight, or preferably not more than 1 part by weight, including cases in which the amount is 0 parts by weight or below the detection limit.

(Content of water-soluble polymer)

The content of the water-soluble polymer in the polishing composition (when two or more kinds are included, the total amount of these) is not particularly limited. To improve polishing performance and surface quality, in certain embodiments the content may be at least 0.0005 wt% for example, or normally at least 0.0025 wt%, or preferably at least 0.005 wt%, such as 0.0075 wt% for example. There is no particular upper limit to the content of the water-soluble polymer, which may be not more than 0.05 wt% for example. Considering the stability at the concentrate and the polishing removal rate, cleanability and the like, the content of the water-soluble polymer in certain embodiments is preferably not more than 0.035 wt%, or more preferably not more than 0.025 wt%, or still more preferably not more than 0.02 wt%, or especially not more than 0.015 wt%, such as not more than 0.0125 wt% for example, or typically not more than 0.01 wt%.

The content of the water-soluble polymer (when two or more kinds are included, the total amount of these) can also be specified in terms of relative content relative to the abrasive content. This is not particularly limited, but in certain embodiments the content of the water-soluble polymer per 100 parts by weight of the abrasive can be for example at least 0.01 parts by weight, while from the perspective of haze reduction and the like the amount is suitably at least 0.1 parts by weight, or preferably at least 0.5 parts by weight, or more preferably at least 1 part by weight, or still more preferably at least 3 parts by weight. The content of the water-soluble polymer per 100 parts by weight of the abrasive may also be not more than 50 parts by weight for example, or not more than 30 parts by weight. Considering the dispersion stability and the like of the polishing composition, in certain embodiments the content of the water-soluble polymer per 100 parts by weight of the abrasive may suitably be not more than 20 parts by weight, or preferably not more than 15 parts by weight, or more preferably not more than 13 parts by weight, or not more than 12 parts by weight.

<Polyvalent organic acid (salt)>

The polishing composition disclosed here contains a trivalent or higher polyvalent organic acid (salt). The inventors discovered that haze on the object of to be polished after polishing could be improved by further including a trivalent or higher polyvalent organic acid (salt) in a polishing composition using a polyvinyl alcohol polymer as a water-soluble polymer. The reasons for these effects are thought to be as follows, although these explanations are not especially limiting. That is, while including a polyvinyl alcohol polymer in a polishing composition containing an abrasive can be useful for protecting the object to be polished and improving the wettability of the surface to be polished after polishing, it can also cause partial aggregation of the abrasive. Minute ununiformities of polishing are likely to occur when the abrasive aggregates, making haze reduction difficult. The trivalent or higher polyvalent organic acid (salt) acts to improve dispersibility by suppressing aggregation of the abrasive in a polishing composition containing an abrasive and a polyvinyl alcohol polymer, and this can then contribute to haze reduction.

A polyvalent organic acid (salt) having three or more functional groups selected from the acid groups and acid salt groups in the molecule is typically used as the polyvalent organic acid (salt). The acid groups may be carboxyl groups, sulfo groups, phosphor groups or the like for example. Each of the functional groups may be selected independently from the group consisting of the carboxyl, carboxyl salt, sulfo, sulfo salt, phosphor and phosphor salt groups. One desirable example of a polyvalent organic acid (salt) is a trivalent or higher polyvalent carboxylic acid (salt). The number of acid groups per molecule of the polyvalent organic acid (salt) (number of carboxy groups in the case of a polyvalent carboxylic acid) is at least 3, such as 3, 4 or 5, and is preferably 3 or 4. In certain embodiments, the polyvalent organic acid (salt) may be a hydroxyl polyvalent organic acid (salt) having at least one hydroxyl group in the molecule. A preferred example of a hydroxyl polyvalent organic acid (salt) is a hydroxyl polyvalent carboxylic acid salt having at least one hydroxyl group and at least 3 carboxyl groups in the molecule. Good abrasive dispersibility tends to be stably obtained by using a hydroxyl polyvalent carboxylic acid (salt) as a polyvalent organic acid (salt). Improvements in surface quality (such as haze reduction) can be better achieved in this way.

The polyvalent organic acid constituting the polyvalent organic acid (salt) may be for example aconitic acid, citric acid, butanetetracarboxylic acid, trimesic acid, trimellitic acid, cyclohexanetricarboxylic acid, pyromellitic acid, mellitic acid, nitrilotris(methylenephosphonic acid) (NTMP), 2-phosphonobutane-1,2,4-tricarboxylic acid (PBTC) or the like. Of these, citric acid (salts) and butanetetracarboxylic acid (salts) and the like are preferred. Salts of polyvalent organic acids may be alkali metal salts such as sodium salts and potassium salts, and ammonium salts and the like. Of these, an ammonium salt is preferred. One kind of polyvalent organic acid (salt) alone or a combination of two or more kinds may be used.

The content of the polyvalent organic acid (salt) is not particularly limited and may be set so as to appropriately achieve the desired effects. In certain embodiments, the content of the polyvalent organic acid (salt) may be for example at least 0.0005 wt%, or at least 0.001 wt%, or at least 0.005 wt%, or at least 0.01 wt% of the total weight of the polishing composition. Increasing the content of the polyvalent organic acid (salt) can improve the dispersibility of the abrasive and lead to even greater haze improvement effects. In embodiments containing two or more kinds of polyvalent organic acids (salts), the content of the polyvalent organic acid (salt) here is the total content of these. Because the haze improvement effect may decline if the content of the polyvalent organic acid (salt) is excessive, in certain embodiments the content of the polyvalent organic acid (salt) may be not more than 5 wt%, or not more than 1 wt%, or not more than 0.3 wt%, or not more than 0.1 wt%, or not more than 0.05 wt%, or not more than 0.02 wt%. These contents can be applied preferably to contents in the polishing slurry (working slurry) supplied to the object to be polished.

In certain embodiments of the polishing composition disclosed here, the preferred content of the polyvalent organic acid (salt) may be specified in terms of relative content relative to the abrasive contained in the polishing composition. Specifically, the content of the polyvalent organic acid (salt) in the polishing composition may suitably be at least about 0.01 parts by weight, or preferably at least about 0.1 parts by weight, or more preferably at least about 0.5 parts by weight, or at least about 0.7 parts by weight per 100 parts by weight of the abrasive contained in the polishing composition. The dispersibility of the abrasive increases as the content of the polyvalent organic acid (salt) increases relative to the content of the abrasive, and a greater haze improvement effect can be achieved as a result. Because the haze improvement effect may decline if the content of the polyvalent organic acid (salt) relative to the abrasive content is excessive, in certain embodiments the content of the polyvalent organic acid (salt) per 100 parts by weight of the abrasive can normally be not more than about 50 parts by weight, or preferably not more than about 20 parts by weight, or more preferably not more than about 10 parts by weight, or not more than about 6 parts by weight. The content of the polyvalent organic acid (salt) per 100 parts by weight of the abrasive may also be not more than 5 parts by weight, or not more than 3 parts by weight for example.

In certain embodiments of the polishing composition disclosed here, the preferred content of the polyvalent organic acid (salt) may be specified in terms of relative content relative to the polyvinyl alcohol polymer contained in the polishing composition. Specifically, the ratio ($A_{OA}/A_{HM}$) of the content ($A_{OA}$) of the polyvalent organic acid (salt) relative to the content ($A_{HM}$) of the polyvinyl alcohol polymer in the polishing composition may appropriately be at least about 0.01 by weight for example, and from the standpoint of obtaining good dispersibility is preferably at least about 0.05, or more preferably at least about 0.1. Because the haze improvement effect may decline if the content of the polyvalent organic acid (salt) relative to the content of the polyvinyl alcohol polymer is excessive, this ratio ($A_{OA}/A_{HM}$) may appropriately be not more than about 10, or preferably not more than about 3, or more preferably not more than about 2, or not more than about 1. This ratio ($A_{OA}/A_{HM}$) may be not more than 0.7 for example.

The preferred content of the polyvalent organic acid (salt) may also be specified in terms of relative content relative to the water-soluble polymer (in embodiments containing a combination of a polyvinyl alcohol polymer and another water-soluble polymer, the combined contents of these) contained in the polishing composition. The ratio ($A_{OA}/A_{HT}$) of the content ($A_{OA}$) of the polyvalent organic acid (salt) relative to the content ($A_{HT}$) of the water-soluble polymer in the polishing composition may suitably be at least about 0.01 by weight for example, and to obtain better dispersibility, is preferably at least about 0.05, or more preferably at least about 0.1. By using a combination of a polyvinyl alcohol polymer and another water-soluble polymer for example and appropriately selecting the other water-soluble polymer, it is possible to favorably implement the polishing composition disclosed here as an embodiment in which the ratio ($A_{OA}/A_{HT}$) is at least about 0.2, or at least about 0.3, or at least about 0.4, or at least about 0.5. Because the haze improvement effect may decline if the content of the polyvalent organic acid (salt) relative to the content of the water-soluble polymer is excessive, this ratio ($A_{OA}/A_{HT}$) is normally not more than about 10, or preferably not more than about 7, or more preferably not more than about 5, or not more than about 3.

In certain embodiments of the polishing composition disclosed here, the preferred content of the polyvalent organic acid (salt) may be specified in terms of the ratio of increase in electrical conductivity due to inclusion of the polyvalent organic acid (salt). The ratio of increase in electrical conductivity is represented by the formula:

$$\text{Electrical conductivity increase ratio} = EC1/EC0$$

based on the electrical conductivity EC1 [mS/cm] of the polishing composition disclosed here and the electrical conductivity EC0 [mS/cm] of the polishing composition minus the polyvalent organic acid (salt). This electrical conductivity increase ratio is normally at least 1 and is typically more than 1. To further enhance the effect of using the polyvalent organic acid (salt), in certain embodiments the electrical conductivity increase ratio is at least 1.3 for example, or at least 1.4, or at least 1.5, or at least 1.7. Considering the dispersion stability and the like of the polishing composition, moreover, the electrical conductivity increase ratio may be less than 10 for example, or normally less than 5. In certain embodiments, the electrical conductivity increase ratio is preferably not more than 3, such as less than 3, or less than 2.5, or less than 2. In certain other embodiments, the electrical conductivity increase ratio may be more than 1 and less than 10 for example, or from 1.3 to less than 7, or from 1.5 to less than 5, or from 2 to less than 4.

A polishing composition whereby haze is effectively improved can be achieved by setting the content of the polyvalent organic acid (salt) so as to obtain such as electrical conductivity increase ratio. Electrical conductivity can be measured by ordinary methods at a liquid temperature of 25°C. A Horiba DS-12 conductivity meter can be used as the measurement equipment for example. In the examples below, electrical conductivity was measured with the above conductivity meter.

In certain embodiments of the polishing composition disclosed here, the electrical conductivity EC1 [mS/cm] of the polishing composition may be at least 0.03 mS/cm, or at least 0.05 mS/cm, or at least 0.08 mS/cm, or at least 0.1 mS/cm, or at least 0.11 mS/cm, or at least 0.12 mS/cm for example considering the dispersibility of the abrasive. Considering the dispersion stability and the like of the polishing composition, the electrical conductivity EC1 [mS/cm] may also be not more than 0.30 mS/cm for example, or not more than 0.20 mS/cm, or not more than 0.15 mS/cm. The haze of a surface of an object to be polished can be effectively improved after polishing with a polishing composition having electrical conductivity conforming to the maximum and/or minimum values described above.

The polishing composition disclosed here may also be implemented favorably as an embodiment in which the electrical conductivity EC1 [mS/cm] of the polishing composition is less than 0.12 mS/cm, or less than 0.11 mS/cm, or less than 0.10 mS/cm, or less than 0.08 mS/cm. In such embodiments having relatively low electrical conductivity EC1, it is desirable to use a combination of a polyvinyl alcohol polymer and another water-soluble polymer as the water-soluble polymer. In these embodiments, the electrical conductivity EC1 [mS/cm] may be more than 0.01 mS/cm for example, and considering the dispersion stability and the like of the polishing composition it may advantageously be over 0.02 mS/cm, or over 0.03 mS/cm, or over 0.04 mS/cm. The haze of a surface of an object to be polished can be effectively improved after polishing with a polishing composition having electrical conductivity conforming to the maximum and/or minimum values described above.

In addition to the polyvalent organic acid (salt) described above, the polishing composition disclosed here may also contain as necessary one or two or more kinds of acids (salts) (hereunder also called the other acid (salt)) selected from the group consisting of the inorganic acids (salts), monovalent organic acids (salts) and divalent organic acids (salts) to the extent that the effects of the invention are not significantly impaired thereby. This other acid (salt) may be used for example to adjust the pH of the polishing composition, adjust the electrical conductivity or the like. To simplify the composition and stabilize performance, the polishing composition disclosed here may preferably be implemented as an embodiment containing substantially no acid (salt) other than the polyvalent organic acid (salt). Containing substantially no acid (salt) other than the polyvalent organic acid (salt) here means that the polyvalent organic acid (salt) constitutes 95 wt% to 100 wt% (typically 98 wt% to 100 wt%) of the combined content of the polyvalent organic acid (salt) and the other acid (salt).

<Basic Compound>

The polishing composition disclosed here contains a basic compound. The basic compound in this Description is a compound having the function of increasing the pH of an aqueous composition when dissolved in water. An organic or inorganic basic compound containing nitrogen, a basic compound containing phosphorus, an alkali metal hydroxide, an alkali earth metal hydroxide and various kinds of carbonates and bicarbonates may be used as the basic compound. Examples of basic compounds containing nitrogen include quaternary ammonium compounds, ammonia, amines (preferably water-soluble amines) and the like. Examples of basic compounds containing phosphorus include quaternary phosphonium compounds. One such basic compound or a combination of two or more kinds may be used.

Specific examples of alkali metal hydroxides include potassium hydroxide and sodium hydroxide. Specific examples of carbonates and bicarbonates includes ammonium hydrogen carbonate, ammonium carbonate, potassium hydrogen carbonate, potassium carbonate, sodium hydrogen carbonate, sodium carbonate and the like. Specific examples of amines include methyl amine, dimethyl amine, trimethyl amine, ethyl amine, diethyl amine, triethyl amine, ethylene diamine, monoethanolamine, N-(beta-aminoethyl) ethanolamine, hexamethylene diamine, diethylene triamine, triethylene tetramine, piperazine anhydride, piperazine hexahydrate, 1-(2-aminoethyl) piperazine, N-methyl piperazine, guanidine, and azoles such as imidazole and triazole and the like. Specific examples of quaternary phosphonium compounds include quaternary phosphonium hydroxides such as tetramethyl phosphonium hydroxide, tetraethyl phosphonium hydroxide and the like.

A quaternary ammonium salt (typically a strong base) such as a tetraalkyl ammonium salt or hydroxyalkyl trialkyl ammonium salt may be used by preference as a quaternary ammonium compound. The anion component of this quaternary ammonium salt may be $OH^-$, $F^-$, $Cl^-$, $Br^-$, $I^-$, $ClO_4^-$, $BH_4^-$ or the like for example. Of these, preferred examples include quaternary ammonium salts having $OH^-$ as an anion, or in other words quaternary ammonium hydroxides. Specific examples of quaternary ammonium hydroxides include tetraalkyl ammonium hydroxides such as tetramethyl ammonium hydroxide, tetraethyl ammonium hydroxide, tetrapropyl ammonium hydroxide, tetrabutyl ammonium hydroxide, tetrapentyl ammonium hydroxide and tetrahexyl ammonium hydroxide; and hydroxyalkyl trialkyl ammonium hydroxides such as 2-hydroxyethyl trimethyl ammonium hydroxide (also called choline) and the like.

Of these basic compounds, for example at least one kind of basic compound selected from the alkali metal hydroxides, quaternary ammonium hydroxides and ammonia can be used by preference. Of these, the tetraalkyl ammonium hydroxides (such as tetramethyl ammonium hydroxide) and ammonia are more preferred, and ammonia is especially preferred.

<Surfactant>

The polishing composition disclosed here may contain a surfactant as necessary. Haze on the surface of the object to be polished after polishing can be reduced still further by containing a surfactant in the polishing composition. An anionic, cationic, nonionic, or amphoteric surfactant may be used. Normally, an anionic or nonionic surfactant is preferred. To reduce foaming and for ease of pH adjustment, a nonionic surfactant is more preferred. Examples of nonionic surfactants include oxalkylene compounds such as polyethylene glycol, polypropylene glycol and polytetramethylene glycol; polyoxyalkylene derivatives (including polyoxyalkylene adducts) such as polyoxyethylene alkyl ethers, polyoxyethylene alkyl phenyl ethers, polyoxyethylene alkylamines, polyoxyethylene fatty acid esters, polyoxyethylene glyceryl ether fatty acid esters and polyoxyethylene sorbitan fatty acid esters; and copolymers (for example, diblock copolymers, triblock copolymers, random copolymers, and alternating copolymers) of multiple kinds of oxyalkylenes. One kind of surfactant alone or a combination of two or more kinds may be used.

Specific examples of nonionic surfactants include block copolymers of ethylene oxide (EO) and propylene oxide (PO) (diblock copolymers, PEO (polyethylene oxide)-PPO (polypropylene oxide)-PEO triblock copolymers and PPO-PEO-PPO triblock copolymers and the like), random copolymers of EO and PO, and polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene-2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, poloxyethylene isostearyl ether, polyoxyethylene oleyl ether, polyoxyethylene phenyl ether, polyoxyethylene octylphenyl ether, polyoxyethylene nonylphenyl ether, polyoxyethylene dodecylphenyl ether, polyoxyethylene styrenated phenyl ether, polyoxyethylene laurylamine, polyoxyethylene stearylamine, polyoxyethylene oleylamine, poloxyethylene monolaurate ester, polyoxyethylene monostearate ester, polyoxyethylene distearate ester, polyoxyethylene monooleate ester, polyoxyethylene dioleate ester, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbitol tetraoleate, polyoxyethylene castor oil, polyoxyethylene hydrogenated castor oil and the like. Of these, examples of preferred surfactants include block copolymers of EO and PO (especially a PEO-PPO-PEO triblock copolymer), random copolymers of EO and PO, and polyoxyethylene alkyl ethers (such as polyoxyethylene decyl ether). A preferred polyoxyethylene alkyl ether is one in which the number of added moles of EO is about 1 to 10 (such as about 3 to 8).

The weight-average molecular weight (Mw) of the surfactant is typically less than 2,000 and is preferably not more than 1,900 (such as less than 1,800) from the standpoint of the filtering and cleanability. Considering the surfactant performance and the like, the Mw of the surfactant may normally be at least 200 and is preferably at least 250 (such as at least 300) from the standpoint of the haze reduction effects and the like. The more preferred range of the Mw of the surfactant may differ according to the kind of surfactant used. For example, when a polyoxyethylene alkyl ether is used as the surfactant, the Mw thereof is preferably not more than 1,500 and may also be not more than 1,000 (such as not more than 500). When a PEO-PPO-PEO triblock copolymer is used as the surfactant, on the other hand, the Mw may be at least 500, or at least 1,000, or at least 1,200.

When the polishing composition disclosed here contains a surfactant, the content thereof is not particularly limited to the extent that the effects of the invention are not impaired. From the standpoint of the cleanability and the like, the content of the surfactant per 100 parts by weight of the abrasive is normally not more than 20 parts by weight and is preferably not more than 15 parts by weight, or more preferably not more than 10 parts by weight (such as not more than 6 parts by weight). To exploit the effects of the surfactant more fully, the surfactant content per 100 parts by weight of the abrasive may suitable be at least 0.001 parts by weight, or preferably at least 0.005 parts by weight, or at least 0.01 parts by weight, or at least 0.05 parts by weight.

When the polishing composition disclosed here contains a surfactant, the weight ratio of the content w1 of the water-soluble polymer to the content w2 of the surfactant (w1/w2) is not particularly limited but may be in the range of 0.01 to 200 for example, or preferably in the range of 0.05 to 100, or more preferably in the range of 0.1 to 70.

To simplify the composition, on the other hand, the polishing composition disclosed here may preferably be implemented as an embodiment substantially containing no surfactant.

<Water>

Deionized water, pure water, ultrapure water, distilled water or the like may be used as the water contained in the polishing composition disclosed here. To avoid impeding the action of other components contained in the polishing composition as much as possible, for example the total content of transition metal ions in the water is preferably not more than 100 ppb. For example, the purity of water can be increased by operations such as removing ion impurities with an ion-exchange resin, removing contaminants with a filter, or distillation or the like.

<Other components>

When necessary, the polishing composition disclosed here may also contain known additives such as antiseptic agents and fungicides used in polishing compositions (typically polishing compositions used in the final polishing steps of silicon wafers) to the extent that this does not greatly detract from the effects of the invention. Examples of antiseptic agents and fungicides include isothiazoline compounds, paraoxybenzoic acid esters, phenoxy ethanol and the like.

The polishing composition disclosed here preferably contains substantially no oxidants. When the polishing composition contains oxidants, for example an oxide layer may be form by oxidation of the silicon wafer surface during polishing, thereby prolonging the necessary polishing time. Specific examples of oxidants here include hydrogen peroxide ($H_2O_2$), sodium persulfate, ammonium persulfate, sodium dichloroisocyanurate and the like. For the polishing composition to contain substantially no oxidants means at least that no oxidants are intentionally contained. Thus, a polishing composition that inevitably contains a small quantity of oxidants derived from the raw materials, manufacturing method or the like (so that for example the molar concentration of oxidants in the polishing composition is not more than 0.0005 mol/L, or preferably not more than 0.0001 mol/L, or more preferably not more than 0.00001 mol/L, or especially not more than 0.000001 mol/L) is included here in the concept of a polishing composition containing substantially no oxidants.

<pH>

The pH of the polishing composition disclosed here is typically at least 8.0, or preferably at least 8.5, or more preferably at least 9.0. The polishing removal rate tends to be higher the greater the pH of the polishing composition. To prevent dissolution of the abrasive (silica particle for example) and suppress loss of mechanical polishing action, the pH of the polishing composition may normally be not more than 12.0, or preferably not more than 11.0, or more preferably not more than 10.8, or still more preferably not more than 10.5.

The pH is determined using a pH meter (such as a Horiba F-23 glass electrode type hydrogen ion concentration indicator), by first performing a 3-point calibration with buffers (phthalate pH buffer, pH 4.01 (25°C), neutral phosphate pH buffer, pH 6.86 (25°C), carbonate pH buffer, pH 10.01 (25°C)), and then placing the glass electrode into the composition to be measured and allowing it to stabilize for at least two minutes before taking a measurement.

<Dispersibility>

In the technology disclosed here, the dispersibility of the abrasive contained in the polishing composition can be understood in terms of a numerical value calculated by the following formula:

$$\text{Dispersibility [nm]} = (d_{84} - d_{16})/2$$

where $d_{84}$ is the particle size [nm] at the point where the cumulative curve of particle size distribution reaches 84%, and $d_{16}$ is he particle size [nm] at the point where the cumulative curve of particle size distribution reaches 16%. This $d_{84}$ and $d_{16}$ can be determined by measurement based on the dynamic light scattering method. A Nanotrac UPA-UT151 dynamic light scattering particle size measurement apparatus manufactured by MicrotracBEL may be used as the measurement apparatus for example. A smaller dispersibility value indicates a narrow particle size distribution. In general, the particle size distribution of the abrasive increases when the abrasive aggregates. Therefore, aggregation of the abrasive is more effectively suppressed in a polishing composition with such a low dispersibility value.

In certain embodiments of the polishing composition disclosed here, the dispersibility value may suitably be less than 50 nm, and is preferably less than 20 nm, or more preferably less than 15 nm, or still more preferably less than 10.8 nm. In a preferred embodiment, the dispersibility value is for example not more than 10.5 nm. The above dispersibility is 0 nm in principle, but from a practical standpoint may be at least 1 nm, or at least 3 nm, or at least 5 nm, or at least 8 nm.

In embodiments containing another water-soluble polymer for example, the polishing composition disclosed here can have a better haze improvement effect if the dispersibility value is less than 14.2 nm. In these embodiments, the dispersibility value may be at least 1 nm for example, or at least 3 nm, or at least 5 nm, or at least 8 nm, or at least 10 nm, or at least 12 nm.

The above dispersibility value may be applied favorably to a polishing composition using an abrasive (such as colloidal silica) with a BET diameter of 10 nm to 35 nm, or preferably 15 nm to less than 32 nm.

<Polishing slurry>

The polishing composition disclosed here is typically supplied in the form of a polishing slurry containing the polishing composition to the surface of an object to be polished, and used to polish the object to be polished. The polishing slurry may be prepared by diluting (typically with water) any of the polishing compositions disclosed here. The polishing composition may also be used as is as the polishing slurry. That is, in the technology disclosed here the concept of a polishing composition encompasses both a working slurry that is supplied to an object to be polished and used to polish the object to be polished, and a concentrate (stock solution of polishing slurry) that is diluted and used as a polishing slurry.

<Concentrate>

Before being supplied to an object to be polished, the polishing slurry disclosed here may be in a concentrated form (that is, in the form of a polishing slurry concentrate). Such a concentrated form of the polishing composition is advantageous from the standpoint of convenience and cost reduction during manufacture, distribution, storage and the like. The concentration ratio is not particularly limited but may be for example 2x to 100x by volume, or normally 5x to 50× (such as 10× to 40x).

Such a concentrate can be diluted when needed to prepare a polishing slurry (working slurry), and this polishing slurry can then be supplied to an object to be polished. Dilution can be accomplished by adding and mixing water with the concentrate.

The content of the abrasive in the concentrate may be not more than 25 wt%, for example. Considering the dispersion stability and filterability and the like of the polishing composition, the content is normally not more than 20 wt%, or more preferably not more than 15 wt%. In a preferred embodiment, the content of the abrasive may be not more than 10 wt%, or not more than 5 wt%. From the standpoint of convenience and cost reduction during manufacture, distribution, storage and the like, the content of the abrasive in the concentrate may be at least 0.1 wt%, or preferably at least 0.5 wt%, or more preferably at least 0.7 wt%, or still more preferably at least 1 wt%.

<Preparing polishing composition>

The polishing composition used in the technology disclosed here may be in a one-agent form, or in a multi-agent form such as a two-agent form. For example, a part A containing at least the abrasive as a component of the polishing composition may be mixed with a part B containing at least some of the remaining components, and these may be mixed and diluted at the appropriate time as necessary to prepare a polishing slurry.

The method for preparing the polishing composition is not particularly limited. For example, the individual components constituting the polishing composition may be mixed using a known mixing apparatus such as a blade stirrer, an ultrasound disperser, or a homogenizer. The mode of mixing these components is not particularly limited, and for example all components may be mixed at once, or they may be mixed in an appropriate sequence.

<Application>

The polishing composition disclosed here may be applied to the polishing of objects to be polished having various materials and shapes. The material of the object to be polished may be a metal or metalloid such as silicon, aluminum, nickel, tungsten, copper, tantalum, titanium or stainless steel, or an alloy of these; a glass material such as quartz glass, aluminosilicate glass or glassy carbon; a ceramic material such as alumina, silica, sapphire, silicon nitride, tantalum nitride or titanium carbide; a compound semiconductor substrate material such as silicon carbide, gallium nitride or gallium arsenide; or a resin material such as polyimide resin or the like. An object to be polished made of multiple such materials is also possible.

It is especially desirable to use the polishing composition disclosed here to polish a silicon surface (typically to polish a silicon wafer). A typical example of a silicon wafer here is a silicon single crystal wafer that is a silicon single crystal wafer obtained by slicing a silicon single crystal ingot.

The polishing composition disclosed here can be applied preferably to a polishing step of an object to be polished (such as a silicon wafer). Before the polishing step with the polishing composition disclosed here, the object to be polished may be subjected to common treatments such a lapping and etching that are applied to objects to be polished in steps prior to polishing steps.

The polishing composition disclosed here can be effectively used in the final polishing step of an object to be polished (such as a silicon wafer) or the polishing step immediately before the final polishing step, and it is especially desirable to use it in the final polishing step. The final polishing step is the last polishing step in the manufacturing process of a target product (that is, the step after which there is no further polishing).

<Polishing>

The polishing composition disclosed here can be used to polish an object to be polished, for example in an embodiment including the following operations. A preferred embodiment of a method for polishing an object to be polished (such as a silicon wafer) with the polishing composition disclosed here is explained below.

That is, a polishing slurry containing any of the polishing compositions disclosed here is prepared. Preparing this polishing slurry may include applying operations such as adjusting the concentration of the polishing composition (by dilution for example) and adjusting the pH and the like to prepare the polishing slurry. The polishing composition may also be used as is as the polishing slurry.

Next, the polishing slurry is supplied to an object to be polished, which is then polished by ordinary methods. In the case of final polishing of a silicon wafer for example, typically a silicon wafer that has passed through a lapping step is set in an ordinary polishing machine, and the polishing slurry is supplied through a polishing pad on the polishing machine to the surface to be polished on the silicon wafer. Typically, the polishing slurry is supplied continuously as the polishing pad is pressed against the surface to be polished on the silicon wafer and the two are moved (rotationally for example) relative to each other. Polishing of the object to be polished is completed through such a polishing step.

The polishing pad used in this polishing step is not particularly limited. For example, a foam polyurethane type, nonwoven cloth type or suede type polishing pad or the like may be used. The polishing pad may or may not contain an abrasive. Normally it is desirable to use a polishing pad containing no abrasive.

An object to be polished that has been polished with the polishing composition disclosed here is typically cleaned. Cleaning can be performed with an appropriate cleaning solution. The cleaning solution is not particularly limited, and for example an SC-1 cleaning solution (mixed solution of ammonium hydroxide ($NH_4OH$), hydrogen peroxide ($H_2O_2$) and water ($H_2O$)) or SC-2 cleaning solution (mixed solution of hydrochloric acid (HCl), $H_2O_2$ and $H_2O$) commonly used in the semiconductor field can be used. The temperature of the cleaning solution may be in the range of from room temperature for example (typically about 15°C to 25°C) up to about 90°C. A roughly 50°C to 85°C cleaning solution can be used by preference to enhance the cleaning effects.

Examples

Some examples of the present invention are explained below, but the intent is not to limit the present invention to what is shown in these examples. In the examples below, parts and percentages are based on weight unless otherwise specified.

«Experimental Example 1»

<Preparation of polishing composition>

(Examples 1 to 3)

An abrasive, a water-soluble polymer, an acid (salt), a basic compound, a surfactant and deionized water are mixed together to prepare the polishing composition of each example. Colloidal silica (average primary particle diameter 25 nm) was used as the abrasive, and the content thereof was 0.175%. Polyvinyl alcohol (unmodified PVA) with a weight-average molecular weight (Mw) of about 70,000 and a degree of saponification of at least 98% was used as the water-soluble polymer, and the content thereof was 0.00875%. Ammonia was used as the basic compound, with a content of 0.005%. Polyoxyethylene decyl ether (C10E05) with 5 moles of added ethylene oxide was used as the surfactant, with a content of 0.00015%. Triammonium citrate was used as the acid (salt) in the amounts shown in Table 1.

(Example 4)

In this example, citric acid was used in the amount shown in Table 1 in place of triammonium citrate. In all other respects the polishing composition of this example was prepared as in Example 1.

(Example 5)

In this example, butane tetracarboxylic acid was used in the amount shown in Table 1 in place of triammonium citrate. In all other respects the polishing composition of this example was prepared as in Example 1.

(Comparative Example 1)

The polishing composition of this example was prepared as in Example 1 except that the triammonium citrate was left out of the composition of Example 1.

(Comparative Examples 2 to 5)

The polishing compositions of Comparative Examples 2 to 5 were prepared as in Example 1 except that the types and amounts of acids (acid salts) shown in Table 1 were used instead of triammonium citrate.

<Measuring dispersibility>

The particle size distributions of the prepared polishing compositions were measured with a Nanotrac UPA-UT151 dynamic light scattering particle size measurement apparatus manufactured by MicrotracBEL. Given $d_{84}$ as the particle size [nm] at the point where the cumulative curve reaches 84%, and $d_{16}$ as the particle size [nm] at the point where the cumulative curve of particle size distribution reaches 16%, numerical values for dispersibility were calculated by the following formula:

$$\text{Dispersibility [nm]} = (d_{84} - d_{16})/2.$$

The results are shown in Table 1. Table 1 also shows electrical conductivity values measured by the methods described above.
The polishing composition of the Comparative Example 1 had a pH of 10.0, while the polishing compositions of the other examples had pH values in the range of 9.0 to 9.9.

<Polishing silicon wafer>

A commercial single crystal silicon wafer 200 mm in diameter that had completed lapping and etching (conduction type: P type, crystal orientation: 100, free of COP (crystal originated particle: crystal defect)) was stock polished under the following polishing conditions 1 to prepare a silicon wafer as the object to be polished. Stock polishing was performed using a polishing slurry containing 1.0% abrasive particles (colloidal silica with a BET diameter of 35 nm) and 0.068% potassium hydroxide in deionized water.

[Polishing conditions 1]

Polishing machine: PNX-322 single wafer polishing device manufactured by Okamoto Machine Tool Works, Ltd.
Polishing load: 15 kPa
Platen rotational speed: 30 rpm
Rotational speed of head (carrier): 30 rpm
Polishing pad: Fujibo FP55
Supply rate of stock polishing slurry: 550 ml/min
Temperature of stock polishing slurry: 20°C
Temperature of platen cooling water: 20°C
Polishing time: 3 min

Using the polishing compositions of the examples prepared above as polishing slurries, silicon wafers that had been stock polished as described above were polished under the following polishing conditions 2.

[Polishing conditions 2]

Polishing machine: PNX-322 single wafer polishing device manufactured by Okamoto Machine Tool Works, Ltd.
Polishing load: 15 kPa
Platen rotational speed: 30 rpm
Rotational speed of head (carrier): 30 rpm
Polishing pad: Fujibo POLYPAS 27NX
Polishing slurry supply rate: 400 ml/min
Polishing slurry temperature: 20°C
Temperature of platen cooling water: 20°C
Polishing time: 4 min

After being polished the silicon wafer was removed from the polishing machine and cleaned with a cleaning solution consisting of $NH_4OH$ (29%), $H_2O_2$ (31%) and deionized water (DIW) in proportions of 1:1:12 by volume (SC-1 cleaning). Specifically, two cleaning tanks, i.e., a cleaning tank 1 and a cleaning tank 2, were prepared, and each of the cleaning tanks was filled with the cleaning solution and maintained at 60°C. Each polished silicon wafer was immersed in the cleaning tank 1 for 5 minutes, dipped in ultrapure water and passed through a rinse tank that applied ultrasound waves, and then immersed in the cleaning tank 2 for 5 minutes before being dipped in ultrapure water and passed through a rinse tank that applied ultrasound waves, and finally dried with a spin dryer.

<Haze measurement>

Using a Surfscan SP2[XP] wafer tester manufactured by KLA Tencor, the haze (ppm) of the silicon wafer surface after cleaning was measured in DWO mode. The results are shown in Table 1 as relative values (haze ratios) given 100% as the haze value in the Comparative Example 1. If the haze value is less than 100%, the haze improvement effect is confirmed to be significant.

[Table 1]

Table 1

| Sample | Acid (salt) | | | Dispersibility [nm] | Electrical conductivity [mS/cm] | Haze ratio DWO [%] |
|---|---|---|---|---|---|---|
| | Type | Valence | Content [wt%] | | | |
| Ex.1 | Triammonium citrate | 3 | 0.0013 | 10.3 | 0.1 | 91 |
| Ex.2 | Triammonium citrate | 3 | 0.005 | 10.3 | 0.13 | 89 |
| Ex.3 | Triammonium citrate | 3 | 0.01 | 10.2 | 0.21 | 98 |
| Ex.4 | Citric acid | 3 | 0.005 | 10.4 | 0.12 | 92 |
| Ex.5 | Butane tetracarboxylic acid | 4 | 0.005 | 10.3 | 0.13 | 90 |
| Comp.Ex. 1 | - | - | - | 11.9 | 0.07 | 100 |
| Comp.Ex. 2 | Ammonium nitrate | 1 | 0.0065 | 11.1 | 0.1 | 100 |
| Comp.Ex. 3 | Potassium nitrate | 1 | 0.002 | 11.7 | 0.09 | 105 |
| Comp.Ex. 4 | Potassium sulfate | 2 | 0.007 | 10.8 | 0.15 | 103 |
| Comp.Ex. 5 | Ammonium tartrate | 2 | 0.005 | 11.2 | 0.09 | 105 |

As shown in Table 1, in the Examples 1 to 5 using polyvalent organic acids (salts) a significant haze improvement effect was confirmed in comparison with the Comparative Example 1. In these examples, the dispersibility values (nm) of the polishing compositions were obviously low in comparison with Comparative Example 1, and it is thought that this contributed to haze improvement. On the other hand, no haze improvement effect in comparison with Comparative Example 1 was seen in the Comparative Examples 2 to 5 using monovalent or divalent acids (salts).

The polishing composition of Reference Example 1, which was prepared as in Example 1 using hydroxyethyl cellulose (HEC) in place of polyvinyl alcohol, had a dispersibility value of 51.2 nm, while the polishing composition of Reference Example 2, which was prepared as in Reference Example 1 but without using triammonium citrate, was 23.3 nm. That is, in contrast to the results shown in Table 1, no improvement in dispersibility from the polyvalent organic acid (salt) was seen with a polishing composition using only HEC as the water-soluble polymer.

«Experimental Example 2»

<Preparation of polishing composition>

(Example 6)

Polyvinyl alcohol (unmodified PVA) with a weight-average molecular weight (Mw) of about 70,000 and a degree of saponification of at least 98% and polyacryloyl morpholine (PACMO) with a weight-average molecular weight (Mw) of about 350,000 were used as water-soluble polymers. The content of the polyvinyl alcohol was 0.00263%, and the content of the polyacryloyl morpholine was 0.00560%. The C10E05 content was 0.00007%, and the triammonium citrate content was 0.0042%. The polishing composition of this example was otherwise prepared as in Example 1.

(Comparative Example 6)

The polishing composition of this example was prepared as in Example 6 except that the triammonium citrate was left out of the composition of Example 6.

<Evaluation>

Dispersibility measurement, silicon wafer polishing, and haze measurement were performed with the prepared polishing compositions as in Experimental Example 1 above. The results are shown in Table 2. The haze value obtained in Example 6 is a relative value (haze ratio) given 100% as the haze value in Comparative Example 6. The results are shown in Table 2.

[Table 2]

Table 2

| Sample | Acid (salt) | | | Dispersibility [nm] | Electrical conductivity [mS/cm] | Haze value DWO [%] |
|---|---|---|---|---|---|---|
| | Type | Valence | Content [wt%] | | | |
| Ex.6 | Triammonium citrate | 3 | 0.0042 | 14.1 | 0.06 | 81 |
| Comp. Ex.6 | - | - | - | 14.2 | 0.02 | 100 |

As shown in Table 2, a comparison of Example 6 and Comparative Example 6 involving polishing compositions containing a combination of a polyvinyl alcohol polymer and another water-soluble polymer confirms a clear haze improvement effect from adding a polyvalent organic acid (salt) to the composition of Comparative Example 6.

Specific examples of the present invention were explained in detail above, but these are only examples, and do not limit the scope of the Claims. The technology described in the Claims includes various changes and modifications to the specific examples given here.

**Claims**

1. A polishing composition comprising an abrasive, a polyvinyl alcohol polymer as a water-soluble polymer, a basic compound, and water, and further comprising a trivalent or higher polyvalent organic acid (salt).

2. The polishing composition according to Claim 1, wherein the polyvalent organic acid (salt) includes a trivalent or higher polyvalent carboxylic acid (salt).

3. The polishing composition according to Claim 1 or Claim 2, wherein the polyvalent organic acid (salt) includes an ammonium salt of a trivalent or higher polyvalent organic acid.

4. The polishing composition according to any one of Claims 1 to 3, wherein dispersibility as represented by formula below is less than 10.8 nm:

$$\text{Dispersibility [nm]} = (d_{84} - d_{16})/2$$

(in which $d_{84}$ is a particle diameter [nm] at a point at which the cumulative curve of a particle size distribution reaches 84%, and $d_{16}$ is a particle diameter [nm] at a point at which the cumulative curve of a particle size distribution reaches 16%).

5. The polishing composition according to any one of Claims 1 to 3, further comprising a water-soluble polymer other than the polyvinyl alcohol polymer as the water-soluble polymer, wherein dispersibility as represented by formula below is less than 14.2 nm:

$$\text{Dispersibility [nm]} = (d_{84} - d_{16})/2$$

(in which $d_{84}$ is a particle diameter [nm] at a point at which the cumulative curve of a particle size distribution reaches 84%, and $d_{16}$ is a particle diameter [nm] at a point at which the cumulative curve of a particle size distribution reaches 16%).

6. The polishing composition according to any one of Claims 1 to 5, wherein a ratio of increase in electrical conductivity due to inclusion of the polyvalent organic acid (salt) is not more than 3.

7. The polishing composition according to any one of Claims 1 to 6, having a pH of 8 to 12.

8. The polishing composition according to any one of Claims 1 to 7, wherein a weight-average molecular weight of the polyvinyl alcohol polymer is not more than $10 \times 10^4$.

9. The polishing composition according to any one of Claims 1 to 8, further comprising a surfactant.

10. The polishing composition according to any one of Claims 1 to 9, wherein the abrasive is a silica particle.

11. The polishing composition according to any one of Claims 1 to 10, for use in a final polishing step for a silicon wafer.

**INTERNATIONAL SEARCH REPORT**

| International application No. |
| --- |
| PCT/JP2020/012622 |

A.  CLASSIFICATION OF SUBJECT MATTER
Int. Cl.  C09K3/14(2006.01)i, B24B37/00(2012.01)i, H01L21/304(2006.01)i
FI: H01L21/304 622D, B24B37/00 H, C09K3/14 550Z, C09K3/14 550D

According to International Patent Classification (IPC) or to both national classification and IPC

B.  FIELDS SEARCHED

Minimum documentation searched (classification system followed by classification symbols)
Int. Cl.  C09K3/14, B24B37/00, H01L21/304

Documentation searched other than minimum documentation to the extent that such documents are included in the fields searched
Published examined utility model applications of Japan     1922-1996
Published unexamined utility model applications of Japan   1971-2020
Registered utility model specifications of Japan           1996-2020
Published registered utility model applications of Japan   1994-2020

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X  A | CN 102786879 A (TSINGHUA UNIVERSITY) 21 November 2012, paragraphs [0034]-[0053], paragraphs [0034]-[0053] | 1-2, 7-11  3-6 |
| X  A | CN 108239484 A (LENS TECHNOLOGY CO., LTD.) 03 July 2018, paragraphs [0016], [0022], [0038], table 1, paragraphs [0016], [0022], [0038], table 1 | 1-2, 7-9, 11  3-6, 10 |
| A | JP 2003-86546 A (SUMITOMO BAKELITE CO., LTD.) 20 March 2003, claim 1 | 1-11 |

☐  Further documents are listed in the continuation of Box C.        ☒  See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 25.05.2020 | 02.06.2020 |

| Name and mailing address of the ISA/ Japan Patent Office 3-4-3, Kasumigaseki, Chiyoda-ku, Tokyo 100-8915, Japan | Authorized officer |
| --- | --- |
| | Telephone No. |

Form PCT/ISA/210 (second sheet) (January 2015)

**INTERNATIONAL SEARCH REPORT**
Information on patent family members

International application No.

PCT/JP2020/012622

| Patent Documents referred to in the Report | Publication Date | Patent Family | Publication Date |
|---|---|---|---|
| CN 102786879 A | 21.11.2012 | (Family: none) | |
| CN 108239484 A | 03.07.2018 | (Family: none) | |
| JP 2003-86546 A | 20.03.2003 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019058620 A
- JP HI1140427 B
- JP 5474400 B
- JP 6029895 B
- JP 6050125 B